# EUROPEAN PATENT APPLICATION

(11) **EP 2 439 317 A1**
(43) Date of publication of application: **11.04.2012**
(21) Application number: 10783447.5
(22) Date of filing: 03.06.2010
(51) Int. Cl.: C30B 29/38, C30B 19/06, C30B 31/10

(54) **PROCESS AND APPARATUS FOR PRODUCTION OF CRYSTALS OF COMPOUND OF METAL BELONGING TO GROUP-13 ON PERIODIC TABLE**

(30) Priority: 04.06.2009 JP 2009135350
(71) Applicant: Mitsubishi Chemical Corporation, Tokyo 108-0014 (JP)
(72) Inventor: SAITO, Yuya, Yokohama-shi Kanagawa 227-8502 (JP)
(74) Representative: HOFFMANN EITLE
(86) International application number: PCT/JP2010/059468
(87) International publication number: WO 2010/140665

(57) **Abstract**

A method for producing a crystal of a metal compound of Group 13 of the periodic table, the method comprises:
preparing a solution or melt containing a raw material and a solvent, and
growing a crystal of a metal nitride of Group 13 of the periodic table in the solution or melt in a crystal producing apparatus, to produce the crystal of a metal nitride of Group 13 of the periodic table,
wherein a member in the crystal producing apparatus, which contacts with the solution or melt comprises: at least one metal selected from the elements of Groups 4 to 6 of the periodic table; and a nitride layer that contains a nitride of at least one selected from the elements of Groups 4 to 6 of the periodic table, on the surface of the member.

## Description

### TECHNICAL FIELD

The present invention relates to a method and apparatus for producing a metal nitride of Group 13 of the periodic table, typified by gallium nitride. More specifically, the present invention relates to a method and apparatus for producing a high-quality, bulk single crystal of a metal nitride of Group 13 of the periodic table.

### BACKGROUND ART

Gallium nitride (GaN) is a useful substance that can be applied to electronic devices, such as light emitting diodes and laser diodes. Generally, methods for producing gallium nitride crystals include vapor phase growth methods, such as metal-organic chemical vapor deposition (MOCVD) and hydride vapor phase epitaxy (HVPE), in which a gallium nitride crystal is epitaxially grown on a substrate such as, *e.g.*, a sapphire or silicon carbide substrate.

In these methods, however, there is a problem that many crystal defects are caused due to the difference in the thermal expansion coefficient or the lattice constant between substrates and GaN, thus deteriorating the characteristics of devices. Further, when different materials are used in combination, vapor phase grown GaN layers warp, causing poor yield and leading to an increase in cost.

The most suitable method to solve these problems is homoepitaxial growth using the same type of materials in the substrates. There exists a strong need at present to establish a technique for producing high-quality gallium nitride single crystals with less lattice defects that are suitable for homoepitaxial growth. A number of liquid phase methods have been proposed as substitutes for the vapor phase methods.

For example, Patent Document 1 suggests a method for producing gallium nitride by adding an alkali metal nitride, such as Li₃N, or an alkaline-earth metal nitride, such as Mg₃N₂, as an additive to a mixture of a nitride of Group 13 as a raw material and a metal halide, and melting the resulting mixture by heating to allow a crystal to grow.

Patent Document 1 also describes elements of Groups 4, 5, 6, 10 and 11 of the periodic table, as materials for members for a reaction vessel or a seed crystal-retaining rod (for example, nickel (Ni), tantalum (Ta), titanium (Ti), palladium (Pd), platinum (Pt), gold (Au) and niobium (Nb)), and others (for example, BN, alumina (Al₂O₃) and quartz (SiO₂)).

Patent Document 2 describes the growth of a single crystal of gallium nitride by performing the crystal growth using a flux containing sodium metal at a pressure of 40 MPa (about 400 atm), a heating temperature of 1,100°C and a nitrogen partial pressure of 200 atm.

Patent Document 2 suggests the use of a ceramic containing at least one nitride selected from titanium nitride and zirconium nitride as a main component for a reaction vessel.

### PRIOR ART DOCUMENTS

### PATENT DOCUMENTS

Patent Document 1: Japanese Patent Application Laid-Open No. 2005-112718
Patent Document 2: Japanese Patent Application Laid-Open No. 2006-265069

### SUMMARY OF THE INVENTION

### PROBLEMS TO BE SOLVED BY THE INVENTION

However, the method described in Patent Document 1 has the following problems. Specifically, when an alkali metal nitride, such as Li₃N, or an alkaline-earth metal nitrides, such as Mg₃N₂, as an additive is added to a mixture of a nitride of Group 13 as a raw material and a metal halide, the additive melted by heating acts as a nitriding component causing a severe nitriding, and corrosion and damage of members such as a reaction vessel and an agitating blade contacted with the nitriding component through the solution.

Also, the use of materials which tend to alloy with metal components present in the solution, such as nickel (Ni) and gold (Au), for the members such as the reaction vessel causes corrosion of and damage to the members. Such corrosion brings about an unexpected change in the composition of components in the solution, leading to trouble of the condition control for crystal growth and deterioration of the quality of the GaN crystals obtained.

Patent Document 2 discloses the use of a ceramic material containing at least one selected from titanium nitride and zirconium nitride, which are difficult to be nitrided and to be alloyed, as a main component for a reaction vessel. However, the ceramic material has problems of its own.

That is, since the ceramic is a sintered material and its processability is extremely poor compared to that of metals, the shape of members which consist of ceramics is greatly limited. Moreover, the ceramic material tends to be brittle, because of its characteristics. This brittleness makes the mechanical durability of the ceramic much inferior to that of metals, essentially shortening the service life of members. As a result, there is also a problem that considerable production costs are incurred.

As discussed above, liquid phase methods for the crystal growth of metal nitrides of Group 13 of the periodic table have some problems, such as considerable increase in production costs and quality deterioration of GaN crystals, which are caused from corrosion and degradation of members. At present, all of these problems are not solved simultaneously.

### MEANS FOR SOLVING THE PROBLEMS

The present inventors have earnestly conducted research to solve the above problems and develop a member simultaneously satisfying plural demands that are difficult to be nitrided and to be alloyed, highly processable and resistant to brittleness, in a liquid phase growth of a metal nitride of Group 13 of the periodic table, and a method for producing the member. Surprisingly, the present inventors have found that the problems can be solved simultaneously by the use of a member including a particular nitride layer formed on the surface of a metal containing a particular element. The present invention has been accomplished based on this finding.

The present invention is directed to a method for producing a crystal of a metal compound of Group 13 of the periodic table, the method comprises:
preparing the solution or melt containing a raw material and a solvent, and
growing the crystal of a metal nitride of Group 13 of the periodic table in the solution or melt in a crystal producing apparatus, to produce the crystal of a metal nitride of Group 13 of the periodic table.
wherein a member in the crystal producing apparatus, which contacts with the solution or melt comprises: at least one metal selected from the elements of Groups 4 to 6 of the periodic table; and a nitride layer that contains a nitride of at least one selected from the elements of Groups 4 to 6 of the periodic table, on the surface of the member.

The present invention is also directed to an apparatus for producing a crystal of a metal compound of Group 13 of the periodic table by growing a crystal of a metal nitride of Group 13 of the periodic table in a solution or melt containing a raw material and a solvent, to produce a crystal of a metal nitride of Group 13 of the periodic table,
wherein the apparatus comprises a member contacting with the solution or melt, and comprising: at least one metal selected from the elements of Groups 4 to 6 of the periodic table; and a nitride layer that contains a nitride of at least one selected from the elements of Groups 4 to 6 of the periodic table, on the surface of the member.

That is, the present invention is accomplished by the features as described herein below.
1. A method for producing a crystal of a metal compound of Group 13 of the periodic table, the method comprises:
   preparing a solution or melt containing a raw material and a solvent, and
   growing a crystal of a metal nitride of Group 13 of the periodic table in the solution or melt in a crystal producing apparatus, to produce the crystal of a metal nitride of Group 13 of the periodic table,
   wherein a member in the crystal producing apparatus, which contacts with the solution or melt comprises: at least one metal selected from the elements of Groups 4 to 6 of the periodic table; and a nitride layer that contains a nitride of at least one selected from the elements of Groups 4 to 6 of the periodic table, on the surface of the member.
2. The method for producing a crystal of a metal compound of Group 13 of the periodic table according to the item 1 above, wherein the nitride layer is formed on the surface of the member by nitriding the surface of the member in advance.
3. The method for producing a crystal of a metal compound of Group 13 of the periodic table according to the item 1 or 2 above, wherein the nitride layer includes a nitride of Group 4 element of the periodic table.
4. The method for producing a crystal of a metal compound of Group 13 of the periodic table according to any one of the items 1 to 3 above, wherein the member includes a metal of Group 4 element of the periodic table.
5. The method for producing a crystal of a metal compound of Group 13 of the periodic table according to the item 4 above, wherein the member includes a metal of Group 4 of the periodic table in an amount of 90% by weight or more.
6. The method for producing a crystal of a metal compound of Group 13 of the periodic table according to any one of the items 3 to 5 above, wherein the metal of Group 4 of the periodic table is at least one of Ti and Zr.
7. The method for producing a crystal of a metal compound of Group 13 of the periodic table according to any one of the items 1 to 6 above, wherein the member is at least one of a reaction vessel, an agitating blade, a seed crystal-retaining rod, a baffle and a gas introducing pipe.
8. The method for producing a crystal of a metal compound of Group 13 of the periodic table according to any one of the items 2 to 7 above, wherein the nitriding is performed by keeping heating the member under a nitrogen.
9. The method for producing a crystal of a metal compound of Group 13 of the periodic table according to any one of the items 2 to 8 above, wherein the nitriding is performed using a nitriding agent.
10. The method for producing a crystal of a metal compound of Group 13 of the periodic table according to the item 9 above, wherein the nitriding agent is at least one of alkali metal nitrides and alkaline-earth metal nitrides.
11. The method for producing a crystal of a metal compound of Group 13 of the periodic table according to any one of the items 1 to 10 above, wherein the raw material is a composite nitride of an alkali or alkaline-earth metal and a metal of Group 13 of the periodic table.
12. The method for producing a crystal of a metal compound of Group 13 of the periodic table according to the item 11 above, wherein the composite nitride of an alkali or alkaline-earth metal and a metal of Group 13 of the periodic table is Li₃GaN₂.
13. The method for producing a crystal of a metal compound of Group 13 of the periodic table according to any one of the items 1 to 12 above, wherein the solvent is an alkali metal halide.
14. The method for producing a crystal of a metal compound of Group 13 of the periodic table according to the item 13 above, wherein the alkali metal halide is at least one of lithium chloride and sodium chloride,
15. The method for producing a crystal of a metal compound of Group 13 of the periodic table according to any one of the items 2 to 14 above, wherein the nitriding is performed under the same conditions as the preparation of a solution or melt containing a raw material and a solvent, and the growth of the crystal of a metal nitride of Group 13 of the periodic table.
16. An apparatus for producing a crystal of a metal compound of Group 13 of the periodic table by growing a crystal of a metal nitride of Group 13 of the periodic table in a solution or melt containing a raw material and a solvent, to produce a crystal of a metal nitride of Group 13 of the periodic table,
   wherein the apparatus comprises a member contacting with the solution or melt, and comprising: at least one metal selected from the elements of Groups 4 to 6 of the periodic table; and a nitride layer that contains a nitride of at least one selected from the elements of Groups 4 to 6 of the periodic table, on the surface of the member.
17. The apparatus for producing a crystal of a metal compound of Group 13 of the periodic table according to the item 16 above, wherein the nitride layer is formed on the surface of the member by minding the surface of the member in advance.
18. The apparatus for producing a crystal of a metal compound of Group 13 of the periodic table according to the item 16 or 17 above, wherein the nitride layer includes a nitride of Group 4 element of the periodic table.
19. The apparatus for producing a crystal of a metal compound of Group 13 of the periodic table according to any one of the items 16 to 18 above, wherein the member includes a metal that contains an element of Group 4 of the periodic table.
20. The apparatus for producing a crystal of a metal compound of Group 13 of the periodic table according to the item 19 above, wherein the member includes a metal of Group 4 of the periodic table in an amount of 90% by weight or more.
21. The apparatus for producing a crystal of a metal compound of Group 13 of the periodic table according to any one of the items 16 to 20 above, wherein the metal of Group 4 of the periodic table is at least one of Ti and Zr.
22. The apparatus for producing a crystal of a metal compound of Group 13 of the periodic table according to any one of the items 16 to 21 above, wherein the member is at least one of a reaction vessel, an agitating blade, a seed crystal-retaining rod, a baffle and a gas introducing pipe.

### EFFECTS OF THE INVENTION

According to the present invention, a crystal of a metal nitride of Group 13 of the periodic table can be grown without causing corrosion of the surface of the member by nitriding components and metal components present in the solution or melt. Therefore, the composition of the solution can be appropriately controlled and high quality of the nitride crystal can be achieved.

Since a material of the member itself is a metal, it is possible to use members of various shapes and the durability of member is also markedly improved. The ease of industrial practice is improved and the production cost can be also greatly reduced.

### BRIEF DESCRIPTION OF THE DRAWINGS

Fig. 1 is a schematic view of a nitriding apparatus used in Reference Experimental Examples 1-3, Reference Comparative Experimental Examples 1-2 and Example 1.
Fig. 2 is a schematic view of a crystal growth apparatus used in Example 1 and Comparative Example 1.

### MODE FOR CARRYING OUT THE INVENTION

The present invention will now be described. The explanation of components as described below is one embodiment of the present invention and the present invention is not limited thereto. A numerical range represented by "to" in the specification represents a range including numerical values described in front of and behind "to" as the minimum value and the maximum value.

### I. Preparation of solution or melt containing raw material and solvent

In the process of preparation of solution or melt containing raw material and solvent, a raw material and a solvent are put into a reaction vessel, and the solvent is melted by heating under an inert gas atmosphere to prepare a solution or melt. The solution or melt may also be prepared in a crystal producing apparatus.

The solvent is typically melted at a temperature of 200 to 1.500°C. preferably 400 to 1,000°C by heating. The solvent is typically heated for 1 to 100 hr, preferably, 1 to 10 hr for melting.

### (Raw material)

In the present invention, examples of raw materials suitable for use in the method for preparing a metal nitride of Group 13 of the periodic table include, but not specifically limited to, materials containing a metal element of Group 13 of the periodic table, nitrogen-containing materials, and compounds containing a metal element of Group 13 of the periodic table and nitrogen. These raw materials may be used alone or in combination of two or more thereof.

The materials containing a metal element of Group 13 of the periodic table may be exemplified by metals, such as gallium metal, aluminum metal and indium metal, and alloys of metal elements of Group 13 of the periodic table, such as GaAl and GaIn.

The nitrogen-containing materials may be exemplified by gases, such as N₂ and NH₃ gases, and alkali and alkaline-earth metal nitrides, such as Li₃N, NaN₃, K₃N, Mg₃N₂, Ca₃N₂, Ba₃N₂ and Sr₃N₂.

The compounds containing a metal element of Group 13 of the periodic table and nitrogen may be exemplified by metal nitrides of Group 13 of the periodic table, such as GaN, AlN and InN, nitrides of alloys of metal of Group 13 of the periodic table, such as AlCaN, InGaN and AlGaInN, and composite nitrides of an alkali or alkaline-earth metal and a metal of Group 13 of the periodic table, such as Li₃GaN₂, Ca₃Ga₂N₄, CaGaN, Ba₃Ga₂N₄ and Mg₃GaN₃.

Among them, the composite nitrides of an alkali or alkaline-earth metal and a metal element of Group 13 of the periodic table are more preferred because when the composite nitrides are dissolved in a molten salt as the solvent, which will be described below, N is included in an amount sufficient to generate nitride crystals containing a metal element of Group 13 of the periodic table in the solution or melt, compared to methods using alkali metal, such as Na flux methods. Li₃GaN₂ is particularly preferred due to its high solubility in a molten salt and its relative ease of synthesis.

There is no particular restriction on the form of the raw material. The raw material may be in the form of a solid, for example, in a powdery, granular or massive form. For example, granular Li₃GaN₂ is preferred as the raw material because it is easy to weigh and it does not float in the solution. Alternatively, the raw material may be in the form of a liquid. A material, such as metal gallium, in the form of a solid at room temperature and in the form of a liquid at the reaction temperature may be also used as the raw material.

The total concentration of the raw material in the solution or melt is typically from 0.0001 mol% to 99.9 mol%, preferably from 0.001 mol% to 10 mol%, more preferably from 0.001 mol% to 0.1 mol%.

### (Solvent)

The kind of the solvent in the present invention is not particularly limited. Examples of solvents suitable for use in the method of the present invention include: molten salts of alkali metal halides, such as lithium chloride, sodium chloride, potassium chloride, cesium chloride, lithium fluoride, sodium fluoride, potassium fluoride, cesium fluoride, lithium bromide, sodium bromide, potassium bromide, cesium bromide, lithium iodide, sodium iodide and potassium iodide; molten salts of alkaline-earth metal halides, such as magnesium chloride, calcium chloride, strontium chloride, barium chloride, magnesium fluoride, calcium fluoride, strontium fluoride, barium fluoride, calcium iodide and barium iodide; alkali metal nitrides, such as lithium nitride, sodium nitride and potassium nitride; alkaline-earth metal nitrides, such as magnesium nitride, calcium nitride, strontium nitride and barium nitride; and melt of metals, such as gallium, lithium, sodium and potassium. These solvents may be used alone or in any combination in any ratio.

In the case of using a composite nitride, such as Li₃GaN₂. described above as the raw material, preferred solvents for dissolving the composite nitride are molten salts of metal halides containing an element of Group 17 of the periodic table, such as lithium chloride, sodium chloride, potassium chloride, cesium chloride, calcium chloride, barium chloride, lithium fluoride, sodium fluoride, potassium fluoride, lithium bromide, potassium bromide, cesium bromide, lithium iodide, sodium iodide, calcium iodide and barium iodide, and mixed molten salts of these metal halides. The mixed molten salts may be prepared by introducing two or more kinds of salts in the form of solids separately into a reaction system and melting these salts by heating. The use of a eutectic salt is preferred in terms of the, internal uniformity of the system. In this case, the eutectic salt may be prepared by melting by heating.

If the molten salts contain impurities, such as water, it is preferred to previously purify the molten salts. The impurities are removed from the molten salts by blowing reactive gases into the molten salts. Examples of such reactive gases include hydrogen chloride, hydrogen iodide, hydrogen bromide, ammonium chloride, ammonium bromide, ammonium iodide, chlorine, bromine and iodine. When a molten salt of a chloride is used as the solvent, hydrogen chloride is particularly preferred as the reactive gas.

### (Inert gas atmosphere)

No particular limitation is imposed on the kind of the inert gas. For example, helium (He), nitrogen (N₂) or argon (Ar) may be suitably used as the inert gas. A material (for example, a metal piece, such as a titanium piece) acting as a scavenger to selectively absorb oxygen or moisture present in a reaction vessel may be entrained with the inert gas.

### II. Growth of crystal of metal nitride of Group 13 of the periodic table

First, the solution or melt containing the raw material and the solvent is charged into a reaction vessel of a crystal producing apparatus. Then, the solution or melt is kept heating to allow a crystal of a metal nitride of Group 13 of the periodic table to grow.

### (Crystal growth method)

The method of performing the crystal growth in the present invention largely corresponds to liquid phase epitaxy. Numerous kinds of crystal growth methods are known in liquid phase epitaxial techniques. Any suitable crystal growth methods may be selected and used in the present invention.

Specifically, gradient transport techniques, slow cooling techniques, temperature cycling techniques, accelerated crucible rotation techniques, top-seeded solution growth techniques, solvent travelling techniques and their modified techniques, such as traveling-solvent floating zone techniques, and evaporation techniques, all of which are mainly used in flux methods, may be used for crystal growth. These techniques may also be used in any combination.

### (Temperature and time)

The temperature for the crystal growth of a metal nitride of Group 13 of the periodic table is typically from 200 to 1,500°C, preferably from 400 to 1,000°C, more preferably from 600 to 800°C, The reaction time for the crystal growth of a metal nitride of Group 13 of the periodic table is typically from 1 to 5,000 hr, preferably 10 to 1,000 hr.

### (Seed crystal)

In the production method of the present invention, it is preferred to, use a crystal or substrate of a metal nitride of Group 13 of the periodic table as a seed for crystal growth (seed crystal). The shape of the seed is not particularly limited. The seed may be plate-like or rod-like in shape. The seed may also be one for homoepitaxial or heteroepitaxial growth.

Specific examples thereof are metal nitrides of Group 13 of the periodic table, such as vapor-phase grown GaN, InGaN and AlGaN seed crystals. Other examples of materials for the seed crystals are also exemplified by metal oxides, such as sapphire, silica, ZnO and BeO, silicon-containing compounds, such as silicon and SiC, and substrates materials for vapor phase growth, such as OaAs.

Materials for the seeds are preferably selected from materials having a lattice constant as close as possible to that of a crystal of a metal nitride of Group 13 of the periodic table grown by the method of the present invention. A bulk crystal may also be produced using a rod-like seed crystal. In this case, a crystal first grows from the seed crystal and continuously grows in both vertical and horizontal directions.

### (Crystal of metal nitride of Group 13 of the periodic table)

Examples of metal nitrides of Group 13 of the periodic table that can be produced by the method of the present invention include: nitrides of metal elements (such as B, Al, Ga and In) of Group 13 of the periodic table (such as GaN, AlN and InN); and nitrides of alloys of metals of Group 13 of the periodic table (such as GaInN and GaAlN). The method of the present invention is particularly suitable for the production of gallium nitride crystals.

According to the method of the present invention, the raw material and the solvent may be charged into a reaction vessel having a stable nitride layer formed on the surface thereof, melted by heating under an inert gas atmosphere to prepare a solution or melt, and kept heating to allow a crystal to grow.

In this case, the existing of water and oxygen should be avoided as much as possible to obtain a higher quality crystal of a metal nitride of Group 13 of the periodic table. Thus, the content of oxygen atoms in the raw material, the solvent and a mixture thereof is typically limited to 5% by weight or less, preferably 2% by weight or less, particularly preferably 0.5% by weight or less.

If the raw material and the solvent are hygroscopic, it is preferred to sufficiently dry the raw material and the solvent by suitable techniques, such as heating and degassing, before charging. It is preferred to rapidly perform the mixing and charging of the respective components under an inert gas atmosphere from which oxygen and moisture are excluded as far as possible.

### (Pressure)

No particular limitation is imposed on the pressure range required for implementing the method of the present invention. A relatively higher gas pressure may be applied in the method of the present invention, but a pressure of gas phase of 100 MPa or less is preferred from the viewpoint of practicality.

### III. Member

The term 'member' as used herein is intended to broadly include, for example, a reaction vessel and accessories thereof, such as a seed crystal-retaining rod, an agitating blade, a baffle and a gas introducing pipe. The material of the member contains at least one metal selected from the elements of Groups 4-6 of the periodic table [titanium (Ti), zirconium (Zr), hafnium (Hf), vanadium (V), niobium (Nb), tantalum (Ta), chromium (Cr), molybdenum (Mo) and tungsten (W)] because of being in contact with the solution or melt provided for crystal growth.

Among them, At least one selected from the elements (Ti, Zr and Hf) of Group 4 of the periodic table is preferred because it facilitates the formation of a nitride layer, which will be explained below, Ti and Zr are most preferred because they have better processability than the other elements of Group 4 of the periodic table.

The member is preferably composed of 90% by weight or more of metal containing at least one selected from the elements of Groups 4-6 of the periodic table, more preferably 99% by weight or more of metal containing at least one selected from the elements of Groups 4-6 of the periodic table, most preferably 90% by weight or more of metal containing the elements of Groups 4 of the periodic table.

The impurities contained in the member, other than the at least one selected from the elements of Groups 4-6 of the periodic table, may include, but not specifically limited to, metals and alloys composed of metal elements other than the at least one metal selected from the elements of Groups 4-6 of the periodic table; and oxides, nitrides and carbides of these metal elements.

The member includes a nitride layer containing a nitride of at least one element selected from the elements of Groups 4-6 of the periodic table, on the surface thereof. Preferably, the nitride layer contains a nitride of at least one metal XᵢNⱼ (X = metal, i, j > 0) selected from the elements of Groups 4-6 of the periodic table.

The nitride XᵢNⱼ has a standard free energy of formation (ΔG^{r}₀) lower than 0, is very stable even in a highly corrosive solution or melt, and protects the member against corrosion by nitriding or metal components present in the solution or melt.

At least 11 selected from the elements of Groups 4-6 of the periodic table may be used as the metal clement X of the nitride XᵢNⱼ. The metal element X may be the same as or different from the main element Z (Z is one selected from the elements of Groups 4-6 of the periodic table) constituting the member. X and Z are preferably the same elements because the nitride layer can be easily formed by nitriding, which will be described below.

The thickness of the nitride XᵢNⱼ is not particularly limited so long as the nitride is stable. The nitride typically has a thickness of 10 nm to 1 mm, preferably 100 nm to 100 µm, more preferably 1 µm to 10 µm.

### (Formation of nitride layer)

In the process for forming nitride layer of the present invention, a nitride layer is formed on the surface of the member. Any method may be used without particular limitation to form the nitride layer so long as the nitride layer is stable.

Specific examples of methods suitable for the formation of the nitride layer include vapor deposition techniques, such as physical vapor deposition (PVD) and chemical vapor deposition (CVD). Alternatively, the nitride layer may be formed by bonding a separately prepared nitride to the surface of the member.

Alternatively, the surface of the member may be directly nitrided to form a nitride layer thereon. In the present invention, direct nitriding of the member surface is more preferred in that the member is not limited in shape and a nitride layer can be relatively easily formed.

It is also preferred to beforehand nitride the member surface to form a nitride layer on the member surface. It is more preferred to nitride the member surface before crystal growth. It is particularly preferred to nitride the member surface before preparation of the solution or melt containing the raw material and the solvent,

Any technique may be used without particular limitation to nitride the member surface so long as a nitride layer formed on the surface is stable, A stable nitride layer may be formed on the member surface by being kept heating at 100 to 1,500°C, preferably 700°C or more, under a nitrogen atmosphere. The nitriding can also be performed using an alkali or alkaline-earth metal nitride as a nitriding agent.

As a specific example, a stable nitride layer may be formed on the member surface by being kept heating the member under a nitrogen, preferably at 200 to 1,500°C, more preferably 600 to 800°C. Specifically, the member is kept heating at least 700°C under a nitrogen atmosphere or at least 200°C under an ammonia atmosphere.

For example, when preparing a nitrogen atmosphere for nitriding, the nitrogen atmosphere is made by flowing N₂ gas, preferably or 1 to 10,000 cm³/min, more preferably of 10 to 1,000 cm³/min.

It is also possible to form a nitride layer on the member surface by using at least one nitriding agent selected from alkali metal nitrides and alkaline-earth metal nitrides, preferably at 100 to 1,500°C, more preferably at 400 to 800°C. More preferably, a stable nitride layer is formed by holding the member into a mixed melt of at least one selected from alkali metal halides and alkaline-earth metal halides and at least one selected from alkali metal nitrides and alkaline-earth metal nitrides.

It is also possible to perform the nitriding in a simple manner by holding the member under the same conditions as those for the process for preparing a solution or melt containing a raw material and solvent and the process for growing a crystal of a nitride of Group 13 of the periodic table. For example, the nitriding may be performed by charging a raw material and a solvent into a reaction vessel and melting by heating the solvent under an inert gas atmosphere to prepare a solution or melt, bringing the solution or melt into contact with the member, and keeping heating for 1 to 200 hr, preferably 30 to 100 hr.

The composition of the solution or melt, the reaction temperature and time for preparing the solution or melt, and the keeping heating temperature at which member is in the solution or melt may be the same as in the process for preparing a solution or melt containing a raw material and solvent and the process for growing a crystal of a nitride of Group 13 of the periodic table.

### IV, Crystal producing apparatus

The crystal producing apparatus in the present invention refers to a producing apparatus in which a crystal of a metal nitride of Group 13 of the periodic table is grown in the solution or melt containing the raw material and the solvent to obtain a crystal of a metal nitride of Group 13 of the periodic table, The process for growing a crystal of a metal nitride of Group 13 of the periodic table is at least carried out in the crystal producing apparatus. The solution or melt preparation process dissolving the raw material in the solvent may be carried out in or outside the crystal growth apparatus.

The crystal producing apparatus includes a container for housing the member, valves and a sealing material, all of which are not in contact with the solution or melt directly, in addition to the member. The member installed in the crystal producing apparatus contains at least one metal selected from the elements of Groups 4-6 of the periodic table and the member includes a nitride layer containing a nitride of at least one selected from the elements of Groups 4-6 of the periodic table, on the surface thereof. In the present invention, the container for housing the member may be, for example, a quartz glass tube or a stainless steel autoclave.

### (Manufacture of semiconductor device)

The producing method of the present invention can be used to produce a crystal of a metal nitride of Group 13 of the periodic table in the manufacture of a semiconductor device. Materials, producing conditions and apparatuses used in other processes may be the same as those used in general semiconductor device manufacturing methods.

### EXAMPLES

### (Reference Experimental Example 1) Nitriding of Ti reaction vessel

With regard to nitriding the surface of a Ti reaction vessel, the following experiment was conducted to confirm the stability of a nitride, TiN (ΔG^{r}₀= -309.3 kJ/mol) formed on the surface or likes, of the reaction vessel.

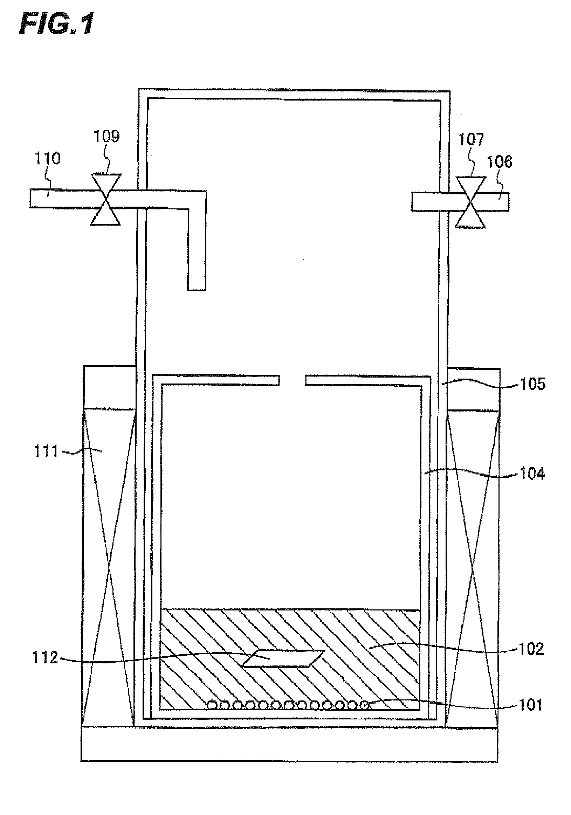

The explanation will be made using Fig. 1. For the purpose of creating the same conditions as those for the method for producing a crystal of a metal compound of Group 13 of the periodic table of the present invention, 0.2 g of Li₃GaN₂ as a nitriding raw material 101 and 1.94 g of LiCl and 0.06 g of NaCl as solvents 102 were sequentially fed into a Ti reaction vessel 104 (outer diameter: 22 mm, inner diameter: 18 mm, height: 18 mm) in an Ar box. Next, the Ti reaction vessel 104 with a position fixing container (not shown) was put in a quartz reaction tube 105, and then it was removed from the Ar box.

After the quartz reaction tube 105 was fixed to an electric furnace 111, the quartz reaction tube was allowed to being reduced pressure atmosphere by using a vacuum pump, Thereafter, a valve 109 was opened to allow N₂ gas to enter the quartz reaction tube via a gas introducing pipe 110. As a result, N₂ atmosphere was created in the quartz reaction tube. A valve 107 was opened to allow the N₂ gas to flow out of the quartz reaction tube at a rate of 100 cm³/min via a gas release pipe 106.

Thereafter, the temperature inside the Ti reaction vessel 104 was raised from room temperature to 745°C over 1 hr using the electric furnace 111. The LiCl and NaCl were melted. The Ti reaction vessel 104 was held at 745°C for 136.5 hr to nitride the inner wall surface thereof.

After completion of the nitriding, heating by the electric furnace was stopped to allow the Ti reaction vessel 104 to naturally cool. The Ti reaction vessel having the nitrided inner wall surface was taken out of the quartz reaction tube. The LiCl and NaCl firmly adhering to the inner wall surface of the reaction vessel were dissolved out with hot water. Inside of the reaction vessel was cleaned with pure water, and dried.

The Ti reaction vessel having the nitrided inner wall surface was weighed. As a result, a weight gain of 15.7 mg between before and after the treatment was confirmed. A strong rigid nitride on the inner wall surface of the Ti reaction vessel was formed by the nitriding. No corrosion was observed.

Thereafter, the procedure similar to the above was repeated to further nitride the reaction vessel, Before and after nitriding, no increase in the weight of the reaction vessel was observed. From these results, it can be seen that the nitrided inner wall surface of the Ti reaction vessel was not changed even if then conducted to the similar procedure and the nitride formed on the surface of the Ti reaction vessel was very stable.

### (Reference Experimental Example 2) Minding of Zr member

With regard to nitriding the surface of a Zr member, the following experiment was conducted to confirm the stability of a nitride, ZrN (ΔG^{f}₀ = -8.6 kJ/mol) formed on the surface or likes, by using a Zr piece as the member 112 for testing.

Specifically, a Zr piece having a height or 20 mm, a width of 10 mm and a thickness of 1 mm as the Zr member was nitrided in the same manner as in Reference Experimental Example 1, except that the minding was performed under the following conditions (which are not a substantial difference in confirming the effects of these comparative experiments).

### Conditions:

· A Y₂O₃ reaction vessel 104 (outer diameter: 31 mm, inner diameter: 25 mm, height: 180 mm) was used.
· A position fixing container (not shown) was not used.
· 1.0 g of Li₃GaN₂ was used as a nitriding raw material 101.
· 9.7 g of LiCl and 0.3 g of NaCl were used as solvents 102.
· After the LiCl and NaCl were melted, the holding time at 745°C was 85.5 hr.
· Nitriding was performed twice (the first holding time was 85.5 hr and the second holding time was 43 hr).

The Zr piece, the member for testing, having the nitrided surface was weighed after the first nitriding and second nitriding, As a result, a weight gain of 3.8 mg after the first nitriding and a weight gain of 1.2 mg after the second minding were confirmed. A strong rigid nitride on the surface of the Zr piece was formed by the nitriding. No corrosion was observed.

These results demonstrate that a stable nitride was formed on the surface of the Zr member after nitriding,

### (Reference Experimental Example 3) Nitriding of member having a Ti content of 90 wt%

With regard to nitriding the surface of a member having a Ti content of 90 wt%, the following experiment was conducted to confirm the stability of a nitride formed on the surface of the member or likes.

Specifically, a Ti-containing material having a screw shape and containing 90 wt% of Ti and a total 10 wt% of Al and V and having a total surface area of 10 cm² was used as a member 112 for testing. After LiCl and NaCl were melted, the member containing 90 wt% of Ti was nitrided in the same manner as in Reference Experimental Example 2, except that nitriding was performed twice with a holding time at 745°C of 65 hr.

The Ti-containing material, the member for testing, having the nitrided surface was weighed after the first nitriding and second nitriding. As a result, a weight gain of 1.9 mg after the first nitriding and a weight gain of 1.3 mg after the second nitriding were confirmed. A strong rigid nitride on the surface of the Ti-comaining member was formed by the nitriding. No corrosion was observed.

These results demonstrate that a stable nitride was formed on the surface of the Ti-containing member after nitriding.

### (Reference Experimental Example 4) Nitriding of Ta member

With regard to nitriding the surface of a Ta member, the following experiment was conducted to confirm the stability of a nitride, TaN (ΔG^{f}₀ = -218.9 kJ/mol) formed on the surface or likes, by using a Ta piece as the member 112 for testing.

Specifically, a Ta piece having a height of 15 mm, a width of 7 mm and a thickness of 0.1 mm was nitrided in the same manner as in Reference Experimental Example 1, except that the nitriding was performed under the following conditions (which are not a substantial difference in confirming the effects of these comparative experiments).

### Conditions:

A Ti reaction vessel 104 (outer diameter: 34 mm, inner diameter: 30 mm, height: 200 mm) was used.
· A position fixing container (not shown) was not used.
· Any solvents 102 were not used.
· A nitriding raw material 101 1 was not used and N₂ gas was used as a nitriding agent (flow rate = 100 cm³/min).
· After heating, the holding time at 850°C was 66 hr.
· Nitriding was performed only once.

The Ta piece, the member for testing, having the nitrided surface was weighed after nitriding. As a result, a weight gain of 1.1 mg between before and after nitriding was confirmed. Thus, a stable nitride was formed on the surface of the Ta member by nitriding using hot N₂ gas as a nitriding agent.

### (Reference Experimental Example 5) Nitriding of Mo member

With regard to nitriding the surface of a Mo member, the following experiment was conducted to confirm the stability of a nitride, Mo₂N (ΔG^{f}₀ = -50.3 kJ/mol) formed on the surface or likes, by using a small Mo container as the member 112 for testing.

Specifically, a container-shaped Mo member having an outer diameter of 10 mm, an inner diameter of 9 mm and a height of 15 mm was nitrided in the same manner as in Reference Experimental Example 1, except that the nitriding was performed under the following conditions (which are not a substantial difference in confirming the effects of these Comparative experiments).

### Conditions:

· A Ti reaction vessel 104 (outer diameter: 34 mm, inner diameter: 30 mm, height: 200 mm) was used.
· A position fixing container (not shown) was not used.
· 14.4 g of LiCl was used as a solvent 102,
· A nitriding raw material 101 was not used and 0.05 g of Mg₃N₂ was used as a nitriding agent.
· After heating, the holding time at 745°C was 150 hr
· Nitriding, was performed only once.

The Mo container, the member for testing, having the nitrided surface was weighed after nitriding. As a result, a weight gain of 1.9 mg between before and after nitriding was confirmed. Thus a stable nitride was formed on the surface of the Mo member by nitriding using the alkaline-earth metal Mg₃N₂ as a nitride agent.

### (Reference Comparative Experimental Example 1) Nitriding of Y₂O₃ member

With regard to nitriding the surface of a Y₂O₃ member, the following experiment was conducted by using a Y₂O₃ piece as the member 112 for testing to compare with Reference Experimental Example 1-3.

Specifically, a cylindrical Y₂O₃ piece as the Y₂O₃ member having a diameter of 8 mm and a thickness of 4 mm was nitrided in the same manner as in Reference Experimental Example 2, except that the nitriding was performed under the following conditions (which are not a substantial difference in confirming the effects of these comparative experiments).

### Conditions:

· After LiCl and NaCl were melted, the holding time at 745°C was 55 hr,
· Nitriding was performed once as in Reference Experimental Example 1.

The Y₂O₃ piece, the member for testing, was weighed after treating as described above. As a result, a weight loss of 40 mg between before and after the treatment was confirmed. By the treatment, the surface was corroded. As described above, when the Y₂O₃ piece is used for the test member, it turned out that the nitriding is not progressed well and a serious damage is caused to the member by the nitriding components and metal components present in the melt.

### (Reference Comparative Experimental Example 2) Nitriding of Pt member

With regard to Nitriding the surface of a Pt member, the following experiment was conducted by using a Pt wire as the member 112 for testing to compare with Reference Experimental Examples 1-3.

Specifically, a Pt wire having a diameter of 0.5 mm and a length of 1.5 cm was nitrided in the same manner as in Reference Experimental Example 2, except that the nitriding, was performed under the following conditions (which are not a substantial difference in confirming the effects of these comparative experiments).

### Conditions:

· After LiCl and NaCl were melted, the holding time at 745°C was 24 hr.
· Nitriding was performed once as in Reference Experimental Example 1.

After the treatment, the Pt wire collapsed simply by being touched with hand, which indicates a severe corrosion. An obvious weight loss was observed. As described above, when the Pt wire is used for the test member, it turned out that the nitriding is not progressed well and a serious damage is caused to the member by the nitriding components and metal components present in the melt.

### [Example 1] nitriding of Ti reaction vessel and growth of GaN crystal

### (Nitriding)

The explanation will be made using Fig. 1. For the purpose of creating the same conditions as those for the method for producing a crystal of a metal compound of Group 13 of the periodic table of the present invention, 0.58 g of Li₃GaN₂ as a nitriding raw material 101 and 5.63 g of LiCl and 0.17 g of NaCl as solvents 102 were sequentially fed into a Ti reaction vessel 104 (outer diameter; 23 mm, inner diameter: 19 mm, height: 50 mm) in an Ar box (NaCl concentration: 3 wt%).

Next, the Ti reaction vessel 104 with a position fixing container (not shown) was put in a quartz reaction tube 105, and then it Was removed from the Ar box, After the quartz reaction tube 105 was fixed to an electric furnace 111, the quartz reaction tube was allowed to being reduced pressure atmosphere by using a vacuum pump.

Thereafter, a valve 109 was opened to allow N₂ gas to enter the quartz reaction tube via a gas introducing pipe 110. As a result, N₂ atmosphere was created in the quartz reaction tube. A valve 107 was opened to allow the N₂ gas to flow out of the quart reaction tube at a rate of 100 cm³/min via a gas release pipe 106. Thereafter, the temperature inside the Ti reaction vessel 104 was raised from room temperature to 745°C over 1 hr using the electric furnace 111, The LiCl and NaCl were melted. The Ti reaction vessel 104 was held at 745°C for 60 hr to nitride the inner wall surface thereof.

After completion of the nitriding, heating by the electric furnace was stopped to allow the Ti reaction vessel 104 to naturally cool. The Ti reaction vessel having the nitrided inner wall surface was taken out of the quartz reaction tube. The LiCl and NaCl firmly adhering to the inner wall surface of the reaction vessel were dissolved out with hot water. Inside of the reaction vessel was cleaned with pure water, and dried. A strong rigid nitride was formed on the inner wall surface of the Ti reaction vessel. No corrosion was observed.

### (Crystal growth)

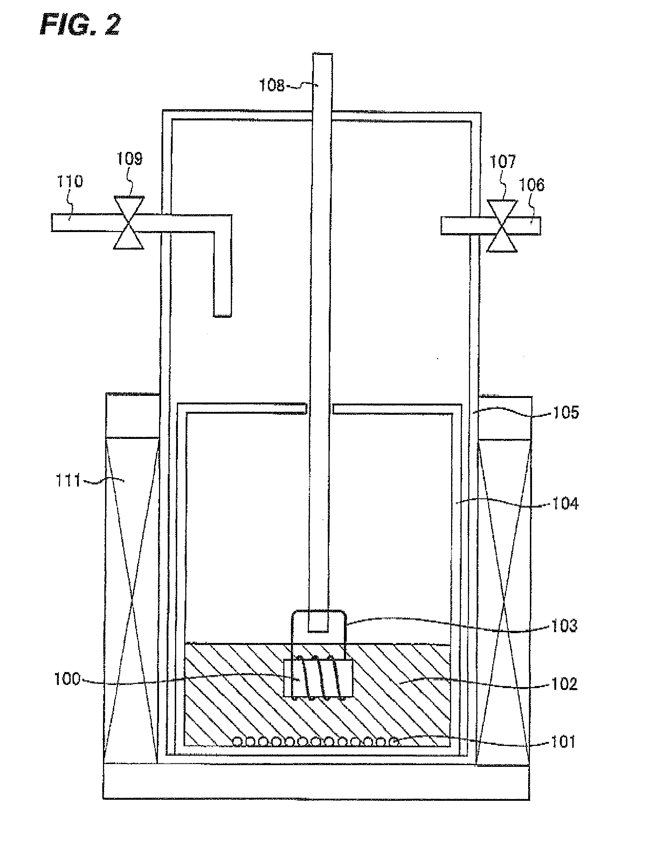

The explanation will be made using Fig. 2. The Ti reaction vessel 104 (outer diameter: 23 mm, inner diameter: 19 mm, height: 50 mm) after minding was again placed in the Ar box and 0.58 g of Li₃GaN² as a nitriding raw material 101 and 5.63 g of LiCl and 0.17 g of NaCl as solvents 102 were sequentially fed thereto (NaCl concentration: 3 wt%).

The Ti reaction vessel 104 with a position fixing container (not shown) was put in a quartz reaction tube 105. Then, a GaN seed crystal 100 (5 mm × 10 mm, thickness 300 µm, Non-polar surface) was connected to a seed crystal-retaining rod made of tungsten 108 using the Ta wire 103 and was inserted into the quartz reaction tube. Thereafter, the quartz reaction tube was taken out from the Ar box.

After the quartz reaction tube was fixed to an electric furnace 111, the quartz reaction tube was allowed to being reduced pressure atmosphere by using a vacuum pump. Thereafter, a valve 109 was opened to allow N₂ gas to enter the quartz reaction tube via a gas introducing pipe 110. As a result, N₂ atmosphere was created in the quartz reaction tube. A valve 107 was opened to allow the N₂ gas to flow out of the quartz reaction tube at a rate of 100 cm³/min via a gas release pipe 106.

Thereafter, the temperature inside the Ti reaction vessel 104 was raised from room temperature to 745°C over 1 hr using the electric furnace 111. The LiCl and NaCl were melted. The Ti reaction vessel 104 was held at 745°C for 70 hr. Thereafter, the melt was cooled from 745°C to 720°C over 1 hr and the seed crystal 100 was dipped therein. The temperature of the melt was held at 720°C for 168 hr while rotating the seed crystal-retaining rod such that the seed crystal was rotated at a speed of 20 rpm to allow a GaN crystal to grow on the seed crystal.

After crystal growth, the seed crystal, on which the CaN crystal was grown, was extracted from the melt. Heating by the electric furnace was stopped to allow the Ti reaction vessel to naturally cool. Thereafter, the seed crystal was taken out of the quartz reaction tube, The LiCl and NaCl firmly adhering to the surface of the seed crystal were dissolved out with hot water. The seed crystal was cleaned with pure water, and dried.

The seed crystal was weighed. As a result, a weight gain of 1.9 mg was confirmed. The part of crystal grown was analysed by X-ray diffraction. The full width at half maximum of the X-ray rocking curve at the (102) plane was 44.3 (arcsec), demonstrating high quality of the GaN crystal. The full width at half maximum of the X-ray rocking curve at the (100) plane was 44.8 (arcsec), also demonstrating high quality of the GaN crystal.

### [Example 2] Nitriding of Zr reaction vessel and growth of CaN crystal

A GaN crystal was grown in the same manner as in Example 1, except that a Zr reaction vessel 104 (outer diameter: 34 mm, inner diameter: 30 mm, height: 200 mm) was used and the nitriding and crystal growth were performed under the following conditions (which are not a substantial difference in confining the effects of these comparative experiment).

### (Nitriding)

### Conditions:

· A position fixing container (not shown) was not used.
· 1.44 g of Li₃GaN₂ was used as a nitriding raw material 101.
· 14.4 g of LiCl was used as a solvent 102.

### (Crystal growth)

### Conditions:

· A position fixing container (not shown) was not used.
· 1.44 g of Li₃GaN₂ was used as a nitriding raw material 101.
· 10.1 of LiCl and 4.3 g of NaCl (NaCl concentration: 30 wit%) were used as solvents 102.
· After the LiCl and NaCl were melted, the first bonding time at 745°C was 7 hr, and then the seed crystal 100 was dipped in the melt and held at 745°C for 91 hr while rotating the seed crystal at a speed of 100 rpm.

After completion of the nitriding, a strong rigid nitride was formed on the inner wall surface of the Zr reaction vessel and no corrosion was observed. After crystal growth, the seed crystal was weighed. As a result, a weight gain of 4.1 mg was confirmed. The part of crystal grown was analyzed by X-ray diffraction. The full width at half maximum of the X-ray rocking curve at the (100) plane was 46.7 (arcsec), demonstrating that even when the Zr reaction vessel was used, high quality of the GaN crystal was obtained.

### [Comparative Example 1] GaN crystal growth using Y₂O₃ reaction vessel

A GaN crystal was grown in the same manner as in Example 1, except that a Y₂O₃ reaction vessel 104 (outer diameter: 31 mm, inner diameter: 25 mm, height: 180 mm) was used, no nitriding was performed and the crystal growth was performed under the following conditions (which are not a substantial difference in confirming the effects of these comparative experiments).

### Conditions:

· A position fixing container (not shown) was not used.
· 2.0 g of Li₃GaN₂ was used as a nitriding raw material 101 and 6.8 g or LiCl and 0.2 g of NaCl were used as solvents 102.
· After the LiCl and NaCl were melted, the first holding time at 750°C was 42 hr, and then the temperature of the melt was lowered from 750°C to 745°C over 1 hr and the seed crystal 100 was dipped in the melt and held at 745°C for 298 hr without rotating the seed substrate.

The seed crystal was weighed. Because of also a longer growing time than Example 1, a weight gain of 9.8 mg was confirmed, However, when the part of crystal grown was analyzed by X-ray diffraction, the full width at half maximum of the X-ray rocking curve at the (102) plane was 220.3 (arcsec), demonstrating that the quality of the crystal was inferior to that of the GaN crystal in Example 1. The full width at half maximum of the X-ray rocking curve at the (100) plane was 195.7 (arcsec), also demonstrating that the quality of the crystal was inferior to that of the GaN crystal in Example 1.

While the invention has been described in detail with reference to specific embodiments thereof, it will be apparent to those skilled in the art that various modifications and variations can be made in the present invention without departing from the spirit and scope of the present invention.
This application is based on Japanese Patent Application No. 2009-135350 filed on June 4, 2009, the contents of which are herein incorporated by reference.

### INDUSTRIAL APPLICABILITY

According to the present invention, a crystal of a metal nitride of Group 13 of the periodic table can be grown without causing corrosion of the surface of the member by components present in the solution. Therefore, the composition of the solution can be appropriately controlled and high quality of the nitride crystal can be obtained. Since a material of member is a metal, it is possible to use members of various shapes and the durability of member is also markedly improved. The ease of industrial practice is improved and the production cost is also greatly reduced.

### EXPLANATION OF REFERENCE NUMERALS

- 100:: Seed crystal (GaN)
- 101:: Raw material (Li₁GaN₂)
- 102:: Melt or solvent (LiCl-NaCl)
- 103:: Wire (Ta)
- 104:: Reaction vessel
- 105:: Quartz reaction tube
- 106:: Gas release pipe
- 107:: Valve
- 108:: Seed crystal-retaining rod (W)
- 109:: Valve
- 110:: Gas introducing pipe
- 111:: Electric furnace
- 112:: Testing member

## Claims

1. A method for producing a crystal of a metal compound of Group 13 of the periodic table, the method comprises:
preparing a solution or melt containing a raw material and a solvent, and
growing a crystal of a metal nitride of Group 13 of the periodic table in the solution or melt in a crystal producing apparatus, to produce the crystal of a metal nitride of Group 13 of the periodic table,
wherein a member in the crystal producing apparatus, which contacts with the solution or melt comprises: at least one metal selected from the elements of Groups 4 to 6 of the periodic table; and a nitride layer that contains a nitride of at least one selected from the elements of Groups 4 to 6 of the periodic table, on the surface of the member.

2. The method for producing a crystal of a metal compound of Group 13 of the periodic table according to claim 1, wherein the nitride layer is formed on the surface of the member by nitriding the surface of the member in advance.

3. The method for producing a crystal of a metal compound of Group 13 of the periodic table according to claim 1 or 2, wherein the nitride layer includes a nitride of Group 4 element of the periodic table.

4. The method for producing a crystal of a metal compound of Group 13 of the periodic table according to any one of claims 1 to 3, wherein the member includes a metal of Group 4 element of the periodic table.

5. The method for producing a crystal of a metal compound of Group 13 of the periodic table according to claim 4, wherein the member includes a metal of Group 4 of the periodic table in an amount of 90% by weight or more.

6. The method for producing a crystal of a metal compound of Group 13 of the periodic table according to any one of claims 3 to 5, wherein the metal of Group 4 of the periodic table is at least one of Ti and Zr.

7. The method for producing a crystal of a metal compound of Group 13 of the periodic table according to any one of claims 1 to 6, wherein the member is at least one of a reaction vessel, an agitating blade, a seed crystal-retaining rod, a baffle and a gas introducing pipe.

8. The method for producing a crystal of a metal compound of Group 13 of the periodic table according to any one of claims 2 to 7, wherein the nitriding is performed by keeping heating the member under a nitrogen.

9. The method for producing a crystal of a metal compound of Group 13 of the periodic table according to any one of claims 2 to 8, wherein the nitriding is performed using a nitriding agent.

10. The method for producing a crystal of a metal compound of Group 13 of the periodic table according to claim 9, wherein the nitriding agent is at least one of alkali metal nitrides and alkaline-earth metal nitrides.

11. The method for producing a crystal of a metal compound of Group 13 of the periodic table according to any one of claims 1 to 10, wherein the raw material is a composite nitride of an alkali or alkaline-earth metal and a metal of Group 13 of the periodic table.

12. The method for producing a crystal of a metal compound of Group 13 of the periodic table According to claim 11, wherein the composite nitride of an alkali or alkaline-earth metal and a metal of Group 13 of the periodic table is Li₃GaN₂.

13. The method for producing a crystal of a metal compound of Group 13 of the periodic table according to any one of claims 1 to 12, wherein the solvent is an alkali metal halide.

14. The method for producing a crystal of a metal compound of Group 13 of the periodic table according to claim 13, wherein the alkali meal halide is at least one of lithium chloride and sodium chloride.

15. The method for producing a crystal of a metal compound of Group 13 of the periodic table according to any one of claims 2 to 14, wherein the nitriding is performed under the same conditions as the preparation of a solution or melt containing a raw material and a solvent, and the growth of the crystal of a metal nitride of Group 13 of the periodic table.

16. An apparatus for producing a crystal of a metal compound of Group 13 of the periodic table by growing a crystal of a metal nitride of Group 13 of the periodic table in a solution or melt containing a raw material and a solvent, to produce a crystal of a metal nitride of Group 13 of the periodic table,
wherein the apparatus comprises a member contacting with the solution or melt, and comprising: at least one metal selected from the elements of Groups 4 to 6 of the periodic table; and a nitride layer that contains a nitride of at least one selected from the elements of Groups 4 to 6 of the periodic table, on the surface of the member.

17. The apparatus for producing a crystal of a metal compound of Group 13 of the periodic table according to claim 16, wherein the nitride layer is formed on the surface of the member by nitriding the surface of the member in advance.

18. The apparatus for producing a crystal of a metal compound of Group 13 of the periodic table according to claim 16, or 17, wherein the nitride layer includes a nitride of Group 4 element of the periodic table.

19. The apparatus for producing a crystal of a metal compound or Group 13 of the periodic table according to any one of claims 16 to 18, wherein the member includes a metal that contains an element of Group 4 of the periodic table.

20. The apparatus for producing a crystal of a metal compound of Group 13 of the periodic table according to claim 19, wherein the member includes a metal of Group 4 of the periodic table in an amount of 90% by weight or more.

21. The apparatus for producing a crystal of a metal compound of Group 13 of the periodic table according to any one of claims 16 to 20, wherein the metal of Group 4 of the periodic table is at least one of Ti and Zr.

22. The apparatus for producing a crystal of a metal compound of Group 13 of the periodic table according to any one of claims 16 to 21, wherein the member is at least one of a reaction vessel, an agitating bade, a seed crystal-retaining rod, a baffle and a gas introducing pipe.
